## Europäisches Patentamt
## European Patent Office
## Office européen des brevets

(19)

(11) Numéro de publication: **0 080 922**
**B1**

(12) **FASCICULE DE BREVET EUROPEEN**

(45) Date de publication du fascicule du brevet:
**17.04.85**

(51) Int. Cl.⁴: **H 03 J 7/16,** H 03 H 7/38,
H 03 H 11/30

(21) Numéro de dépôt: **82402115.8**

(22) Date de dépôt: **19.11.82**

(54) **Dispositif de détection d'impédance optimum de charge d'anode d'un émetteur à tube.**

(30) Priorité: **27.11.81 FR 8122274**

(43) Date de publication de la demande:
**08.06.83 Bulletin 83/23**

(45) Mention de la délivrance du brevet:
**17.04.85 Bulletin 85/16**

(84) Etats contractants désignés:
**DE GB**

(56) Documents cités:
**DE - A - 2 342 482**
**DE - A - 2 923 277**
**GB - A - 568 053**
**US - A - 3 271 684**
**US - A - 3 355 667**

(73) Titulaire: **THOMSON-CSF, 173, Boulevard Haussmann,
F-75379 Paris Cedex 08 (FR)**

(72) Inventeur: **Gaudin, Daniel, THOMSON-CSF
SCPI 173 Bld. Haussmann, F-75379 Paris Cedex 08 (FR)**
Inventeur: **Le Gars, Philippe, THOMSON-CSF
SCPI 173 Bld. Haussmann, F-75379 Paris Cedex 08 (FR)**

(74) Mandataire: **El Manouni, Josiane et al, THOMSON-CSF
SCPI 173, Bld Haussmann, F-75379 Paris Cedex 08 (FR)**

BUNDESDRUCKEREI BERLIN

**0 080 922**

## Description

La présente invention concerne un dispositif de détection d'impédance optimum de charge d'anode d'un émetteur à tube dans une chaîne d'émission haute fréquence.

Un émetteur à tube ne peut être chargé directement par une antenne d'émission dont l'impédance est beaucoup trop faible; on utilise en général, entre l'anode et l'antenne, une cellule d'adaptation utilisant des inductances et des capacités variables que l'on doit accorder selon la fréquence de travail et l'impédance de l'antenne.

Ce réaglage peut être contrôlé de nombreuses façons revenant toutes à s'assurer que l'impédance de charge du tube est optimum, ce qui correspond à un maximum de rendement du tube et à un maximum de puissance rayonnée par l'antenne. Elles sont basées sur des principes différents entraînant également des technologies différentes.

Une première méthode consiste à mesurer le courant HF (I) et la tension HF (V) en sortie du tube. Le rapport de ces deux mesures donne directement le paramètre Za recherché mais dès que la puissance devient élevée il est difficile de prélever par couplage torique l'information de courant.

Une deuxième méthode consiste à mesurer le courant moyen consommé et à faire une comparaison avec la puissance HF émise par l'émetteur. La technologie est simple mais la précision est mauvaise et l'algorithme de réglage est complexe.

Une troisième méthode consiste à substituer à la mesure du rapport V/I les mesures (plus faciles à effectuer) des tensions HF existant respectivement sur l'électrode d'entrée du tube ($V_E$) et sur l'électrode de sortie ($V_S$). Ces deux éléments sont liés par la relation:

$$V_S = S \, Za \, V_E$$

où Za est l'impédance de charge d'anode cherchée et S une caractéristique constante du tube appelée pente. L'adaptation consiste donc à détecter, au cours du réglage de l'impédance de charge d'anode, le moment précis où la phase du rapport $V_S/V_E$ devient égale à 180° (cathode à la masse) et où le module de ce rapport, égal au produit de la pente du tube par sa résistance de charge, devient égal à une valeur définie au préalable. Il n'est pas nécessaire de travailler directement sur le rapport $V_S/V_E$ mais il suffit en fait de comparer en module et en phase les signaux $V_S$ et $V_E$.

Il est connu, pour obtenir plus facilement une convergence de réglage, d'affecter les paramètres de réglage en module et en phase respectivement à un seul des éléments variables constituant la cellule d'adaptation.

Cependant, dans les dispositifs de détection d'impédance optimum de charge d'anode connus jusqu'à présent (notamment par le brevet US-A-3 355 667) et fonctionnant suivant la troisième méthode précitée, la détection d'adaptation en phase, c'est-à-dire la mesure destinée à déterminer la fin du réglge sur la phase, demeure dépendante des opérations de réglage effectuées sur le module, et vice-versa, ce qui ne permet pas de bénéficier pleinement des résultats escomptés par la répartition des paramètres de réglage entre le module et la phase.

La présente invention a pour but d'éviter cet inconvénient.

De plus, le dispositif de détection d'impédance optimum de charge d'anode conforme à l'invention permet, par rapport aux dispositifs connus, d'accroître la précision et de simplifier l'algorithme de réglage, en recherchant non pas des extrémums (variables selon les niveaux) mais des zéros, ce qui permet d'obtenir une grande dynamique de réglage selon la puissance mise en jeu, mais surtout de rendre les réglages indépendants de cette puissance, avec détermination immédiate du sens de variation des éléments de réglage.

Il est également connu, par le brevet GB-A-568 053, de mesurer le désaccord d'un générateur d'oscillations par mesure de la différence de phase entre sa tension d'entrée et sa tension de sortie, à l'aide de moyens pour déphaser de $\frac{\pi}{2}$ ces deux tensions, de moyens pour multiplier les deux tensions ainsi déphasées, et de moyens pour calculer la valeur moyenne du produit obtenu, celle-ci correspondant à la différence de phase entre ces deux tensions.

Selon l'invention, le dispositif de détection d'impédance optimum de charge d'anode d'un émetteur à tube dans une chaîne d'émission haute fréquence,. cette chaîne d'émission comportant, outre l'émetteur à tube, une antenne émettrice et une cellule d'adaptation d'impédance, à éléments variables, interposée entre l'émetteur à tube et l'antenne émettrice, et cette détection consistant à repérer, au cours de la variation de l'impédance présentée à l'anode par la cellule d'adaptation d'impédance, et à partir des tensions d'entrée et de sortie du tube, le passage de l'impédance de charge d'anode du tube par une valeur purement résistive définie au préalable, ce dispositif comporte des moyens pour déphaser de $k \frac{\pi}{2}$ (avec k entier impair, positif ou négatif) la différence de phase existant entre les tensions d'entrée et de sortie du tube, des moyens pour multiplier entre elles les deux tensions ainsi traitées, et des moyens pour calculer la valeur moyenne du produit ainsi obtenu, l'annulation de cette valeur moyenne correspondant au passage de l'impédance de charge d'anode par une valeur purement résistive, ce qui permet de rendre la détection d'adaptation en phase indépendante de la détection d'adaptation en module.

Les objets et caractéristiques de la présente invention apparaîtront plus clairement à la lecture de la description suivante d'un exemple de réalisation, ladite description étant faite en relation avec les dessins ci-annexés dans lesquels:

la figure 1 représente un schéma synoptique d'une chaîne d'émission haute fréquence dans laquelle s'insère un dispositif de mesure de charge d'anode optimum conforme à l'invention;

la figure 2 représente un schéma détaillé d'un dispositif de mesure de charge d'anode optimum conforme à l'invention.

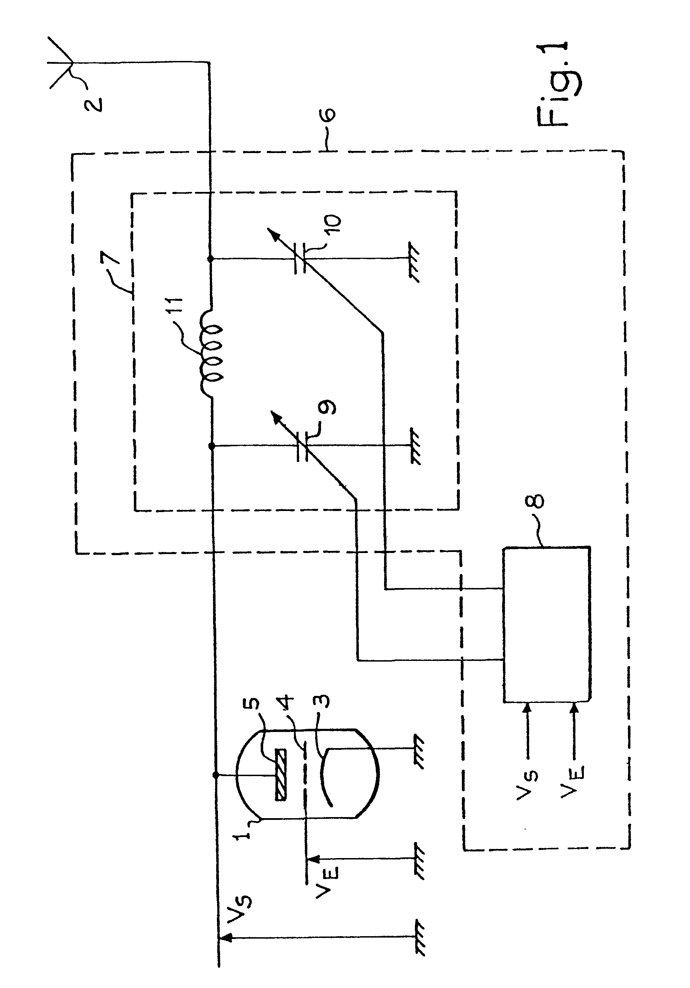

Sur la figure 1 on a représenté très schématiquement une chaîne d'émission haute fréquence comportant un tube émetteur 1 et une antenne émettrice 2. Le tube émetteur 1 comporte une cathode 3, une électrode de commande 4 sur laquelle est appliquée une tension d'entrée $V_E$, et une électrode de sortie 5 sur laquelle on recueille une tension de sortie $V_S$.

Entre le tube émetteur 1 et l'antenne émettrice 2 est interposé un dispositif 6 d'adaptation d'impédances, destiné à adapter l'impédance de l'antenne 2 à une valeur correcte pour l'anode du tube 1. En effet, l'antenne 2 a typiquement une impédance complexe de l'ordre de 50 ohms, alos que le tube 1 a besoin d'une impédance réelle, c'est-à-dire purement résistive, de l'ordre de 2000 ohms.

Le dispositif d'adaptation 6 comporte une cellule 7 d'adaptation d'impédance à éléments variables, et un dispositif 8 de détection d'impédance optimum de charge d'anode, destiné à détecter, au cours de la variation des éléments de la cellule 7, le moment où l'impédance de charge du tube devient purement résistive et égale à la valeur souhaitée.

Pour détecter le moment où l'impédance de charge du tube devient purement résistive, comme le tube est en général monté suivant un montage dit »cathode à la masse«, il est nécessaire de rechercher, non pas le moment où la phase entre $V_S$ et $V_E$ s'annule, mais ou cette phase devient égale à 180°.

La cellule d'adaptation d'impédance 7 comporte plusieurs éléments variables initialement prépositionnés en fonction de la fréquence, à savoir deux condensateurs variables 9 et 10 et une inductance 11 par exemple. L'inductance 11 est conservée constante tout au long du réglage. Par contre l'accord est effectué à l'aide des condensateurs variables. Le condensateur variable 9 est affecté à l'obtention d'un déphasage de 180° entre $V_S$ et $V_E$ tandis que le condensateur variable 10 est affecté à l'obtention d'un bon rapport d'amplitude entre $V_S$ et $V_E$. Ceci est symbolisé sur la figure 1 au moyen des deux commandes distinctes pour ces deux composants.

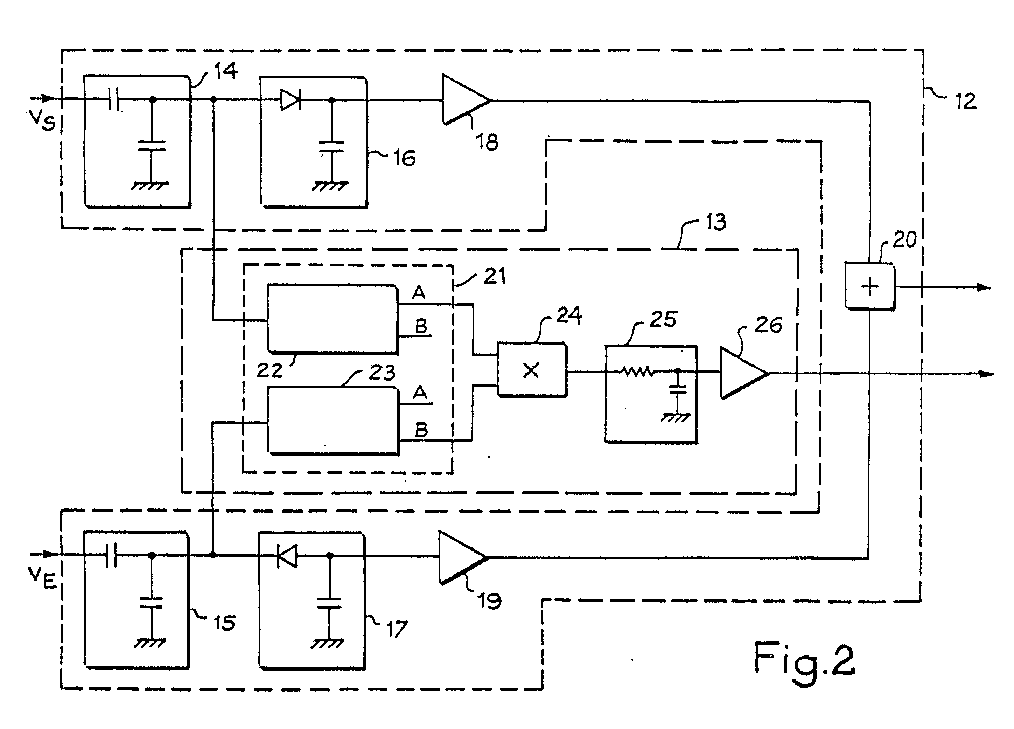

Le dispositif 8 de détection d'impédance optimum de charge d'anode conforme à l'invention permet de rendre les mesures sur la phase entre $V_S$ et $V_E$ totalement indépendants des mesures sur le module du rapport $V_S/V_E$ et vice-versa lorsque l'accord visé est obtenu. Ce dispositif 8 est représenté à la figure 2. Il comporte des moyens 12 de détection d'adaptation en module et des moyens 13 de détection d'adaptation en phase.

Les moyens 12 de détection d'adaptation en module sont classiquement réalisés au moywen de deux diviseurs capacitifs 14 et 15 dont l'un reçoit la tension d'entrée $V_E$ et l'autre la tension de sortie $V_S$. Les rapports de ces deux diviseurs capacitifs sont déterminés de manière que les tensions de sortie $V_{S1}$ et $V_{E1}$ de ces deux diviseurs soient égales lorsque les tensions d'entrée $V_S$ et $V_E$ de ces deux diviseurs sont dans un rapport égal au produit de la pente du tube par sa résistance de charge d'anode souhaitée. Les moyens de détection d'adaptation en module comportent également un circuit de détection d'égalité entre les tensions $V_{E1}$ et $V_{S1}$, réalisé par exemple de la façon suivante.

Les diviseurs capacitifs 14 et 15 sont suivis respectivement de redresseurs-filtres 16 et 17 qui donnent respectivement des signaux proportionnels à la valeur crête des signaux $V_{S1}$ et $V_{E1}$, et de signes contraires.

Chacun des redresseurs-filtres 16 et 17 est suivi d'un amplificateur (18 et 19) et les sorties de ces deux amplificateurs 18 et 19 sont reliées à l'entrée d'un additionneur analogique 20 qui fournit sur sa sortie une information de détection d'adaptation en module.

Comformément à l'invention, les moyens 13 de détection d'adaptation en phase comportent des moyens 21 pour déphaser de $\pm \dfrac{\pi}{2}$ la différence de phase existant entre les tensions $V_S$ et $V_E$.

Les moyens 21 comportent par exemple un premier et un second déphaseurs de 90°, 22 et 23, identiques, munis chacun d'une entrée connectée à la sortie de l'un des diviseurs capacitifs 14 et 15.

Chaque déphaseur est muni de deux sorties référencées A et B dont l'une (A) fournit le signal présent à l'entrée du déphaseur, déphasé d'un déphasage $\alpha$ ($\alpha$ pouvant être quelconque) et l'autre (B) fournit le signal recueilli sur la sortie A déphasé de 90°. Ces déphaseurs sont bien connus dans la technique et on ne les décrira pas de manière plus détaillée. Ce sont par exemple des déphaseurs 90° du type quadripôles passe-tout à réseaux R-C.

Le dispositif de détection d'adaptation en phase comporte également un multiplieur analogique 24 muni de deux entrées reliées respectivement à la sortie A du déphaseur 22 et à la sortie B du déphaseur 23, ou à la sortie B du déphaseur 22 et à la sortie A du déphaseur 23.

Les moyens 13 de détection d'adaptation en phase comportent également un circuit 25 de calcul de valeur moyenne (notamment par filtrage HF), muni d'une entrée reliée à la sortie du multiplieur 24 et d'une sortie qui fournit l'information de détection d'adaptation en phase à travers un amplificateur 26.

Le dispositif 13 de détection d'adaptation en phase représenté sur la figure 2 fonctionne de la façon

suivante.

Soient $\Theta_E$ et $\Theta_S$ les phases respectives des tensions d'entrée $V_E$ et de sortie $V_S$.

Soit d'autre part $\alpha$ le déphasage procuré par les déphaseurs identiques 22 et 23 entre les signaux recueillis sur leurs sorties A et les signaux présents sur leurs entrées.

Soient également $\Theta_{1A}$ et $\Theta_{1B}$ d'une part, $\Theta_{2A}$ et $\Theta_{2B}$ d'autre part, les phases des signaux obtenus respectivement sur les sorties A et B du déphaseur 22 d'une part, et sur les sorties A et B du déphaseur 23 d'autre part.

Toutes ces valeurs sont reliées entre elles par les relations suivantes.

$$\Theta_{1A} = \Theta_S + \alpha,$$

$$\Theta_{1B} = \Theta_S + \alpha + \frac{\pi}{2},$$

$$\Theta_{2A} = \Theta_E + \alpha,$$

$$\Theta_{2B} = \Theta_E + \alpha + \frac{\pi}{2}.$$

Soient maintenant a et b les amplitudes des sibnaux présents respectivement sur les entrées des déphaseurs 22 et 23 et w la plusation de ces signaux. Si l'on applique à l'entrée du multiplieur 24 les signaux obtenus respectivement sur la sortie A du déphaseur 22 et sur la sortie B du déphaseur 23, on obtient en sortie de ce multiplieur:

$$a \cos (wt + \Theta_S + \alpha) \cdot b \cos \left(wt + \Theta_E + \alpha + \frac{\pi}{2}\right),$$

ce qui s'écrit aussi:

$$\frac{ab}{2} \left[ \cos \left(2wt + \Theta_S + \Theta_E + 2\alpha + \frac{\pi}{2}\right) + \cos \left(\Theta_S - \Theta_E - \frac{\pi}{2}\right) \right].$$

La valeur moyenne du premier terme de cette somme étant nulle, la valeur moyenne de cette somme est égale à:

$$\frac{ab}{2} \cos \left(\Theta_S - \Theta_E - \frac{\pi}{2}\right).$$

Ce résultat est obtenu en sortie du circuit 25 de calcul de valeur moyenne, que procéde notamment par filtrage HF de façon à éliminer le premier terme de cette somme.

On sait que l'adaptation en phase a lieu lorsque $\Theta_S - \Theta_E$ est égal à $\pi$. Lorsque

$$\Theta_S - \Theta_E \text{ est égal à } \pi, \quad \Theta_S - \Theta_E - \frac{\pi}{2} \text{ est égal à } \frac{\pi}{2}, \quad \text{et } \frac{ab}{2} \cos \left(\Theta_S - \Theta_E - \frac{\pi}{2}\right)$$

est égal à 0. Or le seul cas où le réglage effectué pour réaliser l'adaptation en phase est indépendant des amplitudes a et b est le cas où

$$\Theta_S - \Theta_E - \frac{\pi}{2}$$

est un multiple de $\frac{\pi}{2}$ . Par conséquent le traitement effectué sur les signaux $V_E$ et $V_S$ conformément à l'inventiuon permet bien de rendre l'adaptation en phase indépendante de l'amplitude de ces signaux.

Les valeurs numériques utilisées dans la description ci-dessus ne constituent qu'un exemple destiné à mieux faire comprendre l'invention. Il faut souligner que tout déphasage de k $\frac{\pi}{2}$ (avec k entier impair positif ou négatif) apporté au déphasage existant entre les signaux $V_S$ et $V_E$, permet d'obtenir le résultat de l'invention.

Il faut également remarquer que le traitement effectué sur la phase de chacun des signaux $V_S$ et $V_E$ pourrait être réalisé de manière quelconque, autre que celle qui a été décrite ci-dessus, pourvu qu'à l'issue de ce traitement la différence de phase entre ces deux signaux soit déphasée de k $\frac{\pi}{2}$ par rapport à ce qu'elle était avant le traitement.

## Revendications

1. Dispositif (8) de détection d'impédance optimum de charge d'anode d'un émetteur à tube (1) dans une chaîne d'émission haute fréquence, cette chaîne d'émission comportant, outre l'émetteur à tube (1), une antenne émettrice (2), et une cellule d'adaptation d'impédance (7), à éléments variables, interposée entre l'émetteur à tube (1) et l'antenne émettrice (2), et cette détection consistant à repérer, au cours de la variation de l'impédance présentée à l'anode par la cellule d'adaptation d'impédance (7), et à partir des tensions d'entrée et de sortie du tube, le passage de l'impédance de charge d'anode du tube par une valeur purement résistive définie au préalable, caractérisé en ce qu'il comporte des moyens (21) pour déphaser de k $\frac{\pi}{2}$ (avec k entier impair, positif ou négatif) la différence de phase existant entre les tensions d'entrée et de sortie du tube (1), des moyens (24) pour multiplier entre elles les deux tensions ainsi traitées, et des moyens (25) pour calculer la valeur moyenne du produit ainsi obtenu, l'annulation de cette valeur moyenne correspondant au passage de l'impédance de charge d'anode par une valeur purement résistive, ce qui permet de rendre la détection d'adaptation en phase indépendante de la détection d'adaptation en module.

2. Dispositif selon la revendication 1, caractérisé en ce que les moyens (21) de traitement de la phase des tensions d'entrée et de sortie du tube comportent un premier et un second déphaseurs de 90° (22 et 23) identiques, aptes à fournir chacun, à partir de l'une des deux tensions d'entrée et de sortie du tube (1), sur une première sortie (A) une première tension déphasée d'une valeur quelconque par rapport à la tension d'entrée du déphaseur, et sur une deuxième sortie (B) une seconde tension déphasée de 90° par rapport à la tension disponible sur la première sortie (A).

3. Dispositif selon les revendications 1 et 2, caractérisé en ce que les moyens de multiplication (24) comportent un multiplieur muni de deux entrées reliées l'une à la première sortie (A) du premier déphaseur (22) et l'autre à la seconde sortie (B) du second déphaseur (23).

4. Dispositif selon les revendications 1 et 2, caractérisé en ce que les moyens de multiplication (24) comportent un multiplieur muni de deux entrées reliées l'une à la seconde sortie (B) du premier déphaseur (22) et l'autre à la première sortie (A) du scond déphaseur (23).

## Patentansprüche

1. Vorrichtung (8) zur Detektion der optimalen Lastimpedanz der Anode einer Senderöhre (1) in einer HF-Sendekette, die außer der Senderöhre (1) eine Sendeantenne (2) und eine Impedanz-Anpassungszelle (7) mit variablen Elementen enthält, die zwischen Senderöhre (1) und Sendeantenne (2) eingefügt ist, wobei die Detektion darin besteht, im Laufe der Veränderung der an der Anode wirksamen Impedanz der Impedanzanpassungszelle (7) anhand der Eingangs- und Ausgangsspannungen der Röhre den Durchgang der Anoden-Lastimpedanz der Röhre durch einen vorbetimmten, rein ohmschen Wert zu ermitteln, dadurch gekennzeichnet, daß sie Mittel (21) zur Phasenverschiebung der Phasendifferenz zwischen der Eingangs- und Ausgangsspannung der Röhre (1) um einen Wert k$\cdot\pi$/2 (wobei k eine ungeradzahlige positive oder negative ganze Zahl ist), Mittel (24) zur multiplikativen Verknüpfung dieser beiden so vorbehandelten Spannungen und Mittel (25) aufweist, um den Mittelwert des so erhaltenen Produkts zu berechnen, wobei die Annullierung dieses Mittelwertes dem Durchgang der Anoden-Lastimpedanz durch einen rein ohmschen Wert entspricht, wodurch es möglich ist, die Ermittlung der Phasenanpassung unabhängig von der Ermittlung der Modulanpassung zu machen.

2. Vorrichtung nach Anspruch 1, dadurch gekennzeichnet, daß die Mittel (21) für die Phasenbehandlung der Eingangs- und Ausgangsspannung der Röhre einen ersten und einen zweiten 90°-Phasenschieber (22 und 23) aufweisen, die einander gleichen und jeweils geeignet sind, ausgehnd von der Eingangsspannung oder der Ausgangsspannung der Röhre (1) auf einem ersten Ausgang (A) eine erste, um einen beliebigen Wert bezüglich der Eingangsspannung des Phasenschiebers verschobene Spannung und an einem zweiten Ausgang (B) eine zweite, um 90° bezüglich der am ersten Ausgang (A) verfügbaren Spannung phasenverschobene Spannung zu liefern.

3. Vorrichtung nach den Ansprüchen 1 und 2, dadurch gekennzeichnet, daß die Multipliziermittel (24) einen Multiplizierer mit zwei Eingängen aufweisen, von denen der eine an den ersten Ausgang (A) des ersten Phasenschiebers (22) und der andere an den zweiten Ausgang (B) des zweiten Phasenschiebers (23) angeschlossen ist.

4., Vorrichtung nach den Ansprüchen 1 bis 2, dadurch gekennzeichnet, daß die Multipliziermittel (24) einen Multiplizierer mit zwei Eingängen aufweisen, von denen der eine an den zweiten Ausgang (B) des ersten Phasenschiebers (22) und der andere an den ersten Ausgang (A) des zweiten Phasenschiebers (23) angeschlossen ist.

**Claims**

1. A device (8) for detecting the optimum anode load impedance of a tube (1) transmitter in a high frequency transmission chain, this transmission chain comprising, besides the tube transmitter (1), a transmitter antenna (2), and an impedance matching cell (7) with variable elements, interposed between the tube transmitter (1) and the transmission antenna (2), and this detection consisting in detecting, during the variation of the impedance presented to the anode by the impedance matching cell (7), and from the input and output voltages of the tube, the passing of the anode load impedance of the tube through a previously defined purely resistive value, characterized in that means (21) are provided for phase shifting by $k \cdot \pi/2$ (with k being a positive or nagative uneven integer) the phase difference existing between the input and output voltages of the tube (1), means (24) for multiplying together the two voltages thus processed, and means (25) for calculating the mean value of the product thus obtained, cancelling out of this mean value of the product thus obtained, cancelling out of this mean value corresponding to the passing of the anode load impedance through a purely resistive value, which allows the phase matching cetection to be made independent of the modulus matching detection.

2. A device as claimed in claim 1, characterized in that the means (21) for treating the phase of the input and output voltages of the tube comprise identical first and second 90° phase shifters (22 and 23), each adapted to supply, from one of the two input and output voltages of the tube (1), at a first output (A), a first voltage phase shifted by any value with respect to the input voltage of the phase shifter, and at a second output (B), a second voltage phase shifted by 90° with respect to the voltage available at the first output (A).

3. A device as claimed in claims 1 and 2, characterized in that the multiplication means (24) comprise a multiplier having two inputs connected one to the first output (A) of the first phase shifter (22) and the other to the second output (B) of the phase shifter (23).

4. A device as claimed in claims 1 and 2, characterized in that the multiplication means (24) comprise a multiplier having two inputs connected one to the second output (B) of the first phase shifter (22) and the other to the first output (A) of the second phase shifter (23).

Fig.1

0 080 922

Fig.2

0 080 922